(19) Europäisches Patentamt / European Patent Office / Office européen des brevets

(11) **EP 4 040 400 B1**

(12) **EUROPEAN PATENT SPECIFICATION**

(45) Date of publication and mention
of the grant of the patent:
**10.09.2025 Bulletin 2025/37**

(21) Application number: **21210732.0**

(22) Date of filing: **26.11.2021**

(51) International Patent Classification (IPC):
*G06V 10/75* (2022.01)     *G06V 10/98* (2022.01)
*G06T 7/00* (2017.01)     *G05D 1/00* (2024.01)
*G06V 10/82* (2022.01)     *H04N 23/63* (2023.01)
*H04N 23/60* (2023.01)     *H04N 23/661* (2023.01)
*H04N 23/695* (2023.01)

(52) Cooperative Patent Classification (CPC):
**G06V 10/98; G05D 1/0094; G06T 7/0002;
G06V 10/82; H04N 23/632; H04N 23/633;
H04N 23/64; H04N 23/661; H04N 23/695;**
G06T 2207/20084; G06T 2207/30168;
G06V 2201/06

(54) **GUIDED INSPECTION WITH OBJECT RECOGNITION MODELS AND NAVIGATION PLANNING**

GEFÜHRTE INSPEKTION MIT OBJEKTERKENNUNGSMODELLEN UND NAVIGATIONSPLANUNG

INSPECTION GUIDÉE AVEC MODÈLES DE RECONNAISSANCE D'OBJET ET PLANIFICATION DE NAVIGATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **11.12.2020 US 202017119896**

(43) Date of publication of application:
**10.08.2022 Bulletin 2022/32**

(73) Proprietor: **Hitachi, Ltd.**
**Tokyo 100-8280 (JP)**

(72) Inventors:
• **GONZALES DIAZ, Maria Teresa**
  **Santa Clara, 95054 (US)**
• **ARANTES, Adriano S.**
  **Santa Clara, 95054 (US)**
• **GHOSH, Dipanjan**
  **Santa Clara, 95054 (US)**
• **ALAM, Mahbubul**
  **Santa Clara, 95954 (US)**
• **SIN, Gregory**
  **Santa Clara, 95054 (US)**
• **GUPTA, Chetan**
  **Santa Clara, 95054 (US)**

(74) Representative: **Manitz Finsterwald**
**Patent- und Rechtsanwaltspartnerschaft mbB**
**Martin-Greif-Straße 1**
**80336 München (DE)**

(56) References cited:
US-A1- 2017 345 317     US-A1- 2018 321 692
US-A1- 2020 111 267     US-A1- 2023 206 387

**Description**

**BACKGROUND**

**Field**

The present disclosure is generally directed to inspection systems, and more specifically, to guided inspection with object recognition models and navigation planning.

**Related Art**

Related art visual acquisition processes are performed using fixed cameras with limited flexibility and quality control. Related art mobile data acquisition systems have introduced cameras manipulated by operators (e.g., by humans or low-cost robots). In related art implementations, systems involving visual inspection utilize a rule-based navigation planning for acquiring images from assets using mobile technology. However, such related art systems do not use data quality control to validate camera inputs subject to localization, navigation and uncertainty in conditions.

Related art robotics systems with autonomous navigation for known or semi-known environment have been utilized. SLAM (Simultaneous localization and mapping) methods solved the localization of cameras and objects with 3D-map reconstruction of the environment. Navigation models have been mostly developed using geometric methods with graphs and shortest path algorithms. Autonomous systems commonly build 3D maps of known environments using CAD (Computer-aided design) software that is later used to map the state of the environment for real time exploration. These systems use specialized hardware that facilitates environment sensing like LiDAR (Light Detection and Ranging), or 3D (RGB-D) cameras.

Although SLAM is considered as somewhat of solved problem, there are still challenges related to dynamic elements, illumination, weather or seasons that limits the precision and generalization of the technology. Several related art implementations for specialized industrial autonomous robots based on 3D and CAD models have been utilized.

Other related art implementations have introduced deep learning architectures for environment mapping and navigation to overcome SLAM challenges related to dynamic environment conditions, and object generalization. For example, one related art approach involves using Convolutional Neural Networks (CNN) and Long-Short Term Memory networks (LSTM) for navigation over time for unknown environments. In another related art implementation, there are systems for indoor navigation using CNN models that recognize place, rotation and side of objects. Furthermore, a visual scene recognition with segmentation models, and reinforcement learning (RL) for autonomous exploration can also be utilized.

US 2018/321692 A1 discloses a robotic inspection system monitoring an asset via an autonomous-driven inspection performed by a drone. A 3-dimensional model of a travel path with respect to a 3-dimensional virtual asset is stored and converted into a physical travel path about a physical asset which corresponds to the virtual asset. The 3-dimensional movement of the robot is controlled based on the physical travel path wherein data is captured at one or more regions of interest (ROIs) wherein information concerning the captured data is stored. US 2017/345317 A1 teaches a method and system for dynamic routing of a drone wherein the drone receives a first flight mission and captures data according to the first flight mission by a sensor of the drone, e.g. a camera. The quality of the captured data is then assessed and compared to a predefined threshold. If the data quality is below the predefined threshold the drone continues with a second flight capturing new data according to the second flight, wherein if the data quality is above the predefined threshold, the drone continues with capturing data according to the current flight mission. US 2020/0111267 A1 discloses a method for rendering augmented reality content in which objects are detect and characterized in 2D frames. US 2023/0206387 A1 discloses a computer vision system in which a search is performed on 2D images.

**SUMMARY**

It is an object of the present invention to provide a non-transitory computer readable medium, storing instructions for automating an inspection checklist for an object to be inspected, a non-transitory computer readable medium, storing instructions for executing a process, and a method for automating an inspection checklist for an object to be inspected, wherein the complexity of the system and the amount of necessary resources are reduced.

This object is satisfied by the subject-matters of the independent claims.

In contrast to the related art, example implementations described herein are directed to improving quality of visual input for the inspection process and assisting the inspection process using mobile technology for automated inspection in semi-known environments. The example implementations described herein utilize 2D deep learning models without complex 3D-map reconstruction and scene segmentation which have not been used previously in this context in the related art.

Example implementations described herein involve a guided data acquisition approach to ensure the quality of data collected and inspection conclusions in automated visual inspection process. Automated visual inspection systems are highly impacted by aspects like occlusion, orientation, lighting conditions, assets, dimensions and the overall context of the object of inspection. As a result of such aspects, the inspection data collected may have poor quality and therefore confidence conclusions can be uncertain.

Example implementations described herein involve mobile data acquisition methods that make use of cameras manipulated by operators such as humans or robots. Mobile systems provide the flexibility to scan assets in trailers, trains, cranes, buildings or windy electric systems where fixed cameras are not suitable. However, adding camera mobility increases the uncertainty and complexity making it difficult to guarantee that inspection is done properly. Mobile acquisition systems utilize control mechanisms to reduce the uncertainty from two main sources: object localization (commonly referred as mapping in computer vision) and the steps to complete the process (inspection navigation). For example, the operator needs to understand the asset to inspect, its viewpoints of interest and the navigation trajectory to reach these viewpoints. However, there is uncertainty whether the operator actually follows the planned trajectory, focusses to asset according to the requirements and performs the actions according to the checklist (e.g. capture correct dimensions of the asset or follow the trajectory to complete all viewpoints). The quality of the visual input can be important as it directly impacts the quality of the conclusions that can be extracted to determine problems (e.g. damage or degradation of the assets). Therefore, a control method needs to indicate whether or not the process is completed with acceptable indicators.

Example implementations address the problems of the related art by introducing mobile infrastructure in which the operator (human or robot) can manipulate the camera to improve visual input. The proposed mobile technology is enhanced with an automated and reliable quality control method to increase quality of data collection. The example implementations apply object recognition models to evaluate the visual input by localizing target objects, and also evaluate valid or invalid conditions such as dimensions, free-obstacle, brightness, and so on. The example implementations also include a navigation planner which recommends inspection paths using object localization to reach the valid viewpoints. According to the invention, the proposed planner localizes objects in 2D instead of related art approaches that use complex 3D-map or scene reconstruction. Hence, the example implementations are faster than a 3D-map reconstruction model. Finally, this approach demonstrates a method to collect images with quality using a general object recognition models that can identify valid viewpoints with acceptable accuracy. If the models detect invalid viewpoints, the method includes a rule-based recommender to adjustments to improve the asset view.

Inspection is a critical process that increases the quality of products and services, prevents accidents and reduces downtime by proactively identifying defects and failures. Several efforts to improve the inspection process have included technologies to automate data collection using sensors or robots and asset evaluation via computer vision. However, automated data collection is mostly limited to fixed infrastructure e.g. cameras mounted on fixed points or robotic arms. On the other hand, several industrial use cases need flexible data acquisition systems that support automated inspection of assets where a fixed infrastructure is not suitable (e.g. large or dynamic dimensions of the inspection asset or field).

Aspects of the present disclosure can involve a computer program, storing instructions for automating an inspection checklist for an object to be inspected, the instructions including capturing two-dimensional images of the object by a camera and generating a navigation pathway around the object for the camera based on the inspection checklist and captured two-dimensional images of the object, wherein the object is localized in 2D using an object mapping (300) including models to identify the object (501) in 2D using the camera images, wherein the models provide 2D localization with a bounding box in the camera images; instructing the camera to navigate along the navigation pathway and capture images along the navigation pathway; evaluating a quality of the captured images based on requirements in the inspection checklist; for ones of the captured images meeting the requirements, storing those images; and for other ones of the captured images not meeting the requirements, instructing the camera to adjust navigation and actions to adjust the camera based on the evaluation. The computer program can be stored in a non-transitory computer readable medium to be executed by one or more processors.

Aspects of the present disclosure can involve a method for automating an inspection checklist for an object to be inspected, the method including capturing two-dimensional images of the object by a camera and generating a navigation pathway around the object for the camera based on the inspection checklist and captured two-dimensional images of the object, wherein the object is localized in 2D using an object mapping (300) including models to identify the object (501) in 2D using the camera images, wherein the models provide 2D localization with a bounding box in the camera images; instructing the camera to navigate along the navigation pathway and capture images along the navigation pathway; evaluating a quality of the captured images based on requirements in the inspection checklist; for ones of the captured images meeting the requirements, storing those images; and for other ones of the captured images not meeting the requirements, instructing the camera to adjust navigation and actions to adjust the camera based on the evaluation.

## BRIEF DESCRIPTION OF DRAWINGS

FIG. 1A to 1C illustrates examples of data acquisition for semi-controlled environments using a pre-defined viewpoint checklist, in accordance with an example implementation.

FIG. 2 illustrates an example flow for the inspection process, in accordance with an example implementation.

FIG. 3 illustrates the various components of the present solution, in accordance with an example implementation.

FIG. 4A illustrates an example 2D map and paths for an object, in accordance with an example implementation.

FIG. 4B illustrates an example logical plan, in accordance with an example implementation.

FIG. 5A illustrate an example of a management database for inspection list 201, in accordance with an example implementation.

FIG. 5B illustrates an example of a flow for automating an inspection checklist for an object to be inspected, in accordance with an example implementation.

FIG. 5C illustrates a flow for a process on a plurality of two-dimensional images captured by a camera, in accordance with an example implementation.

FIG. 6A illustrates an example system architecture, in accordance with an example implementation.

FIGS. 6B to 6F illustrate example interfaces that can be implemented on a mobile device or a robot/drone, in accordance with an example implementation.

FIG. 7A illustrates an example hardware diagram for a robotic camera, in accordance with an example implementation.

FIG. 7B illustrates an example of a computing device, in accordance with an example implementation.

FIG. 8 illustrates an example computing environment with an example computer device suitable for use in some example implementations.

## DETAILED DESCRIPTION

The following detailed description provides details of the figures and example implementations of the present application. Reference numerals and descriptions of redundant elements between figures are omitted for clarity. Terms used throughout the description are provided as examples and are not intended to be limiting. For example, the use of the term "automatic" may involve fully automatic or semi-automatic implementations involving user or administrator control over certain aspects of the implementation, depending on the desired implementation of one of ordinary skill in the art practicing implementations of the present application. Selection can be conducted by a user through a user interface or other input means, or can be implemented through a desired algorithm. Example implementations as described herein can be utilized either singularly or in combination and the functionality of the example implementations can be implemented through any means according to the desired implementations.

Example implementations involve guided visual data acquisition having the process of collecting data with quality control assisted by an automated system for a regular visual inspection. In example implementations described herein, the acquisition process is performed by operators, e.g., humans using devices like phones or tablets, or robots with mounted cameras such as drones or bots (low-cost robots). Quality control is defined as the method to ensure that the visual input satisfies a set of requirements (e.g. object view, desired dimensions, free-obstacle, or lighting level) to be considered as valid record. This record is used later for other processes like damage detection, degradation monitoring, and so on. A regular visual acquisition process usually follows a checklist plan which is defined as a set viewpoints $V$ and actions $A$ to perform in a semi-controlled environment. For each viewpoint $v_i$, the operator performs actions $a_i$ to collect a visual input that captures the status of an asset.

A semi-controlled environment involves a planned inspection field and the planned paths (trajectories) $P$ that the operator(s) can navigate within the semi-known environment. For instance, an operator moves according to the inspection points defined by the planned checklist for the vehicle inspection. If the operator is a robot, the system assumes a starting point in which the robot should start to follow the planned paths. If the operator is a human, the system assumes that he/she can start at any valid viewpoint of the checklist, and later follow the planned plans to complete the inspection. For each viewpoint, the operator can adjust the camera view, position, brightness, and so on, to satisfy $R$ quality requirements of the asset e.g. dimensions, orientation, lightning condition. The quality of the visual input directly impacts the quality of the information that can be extracted to determine damage or degradation problem of the assets.

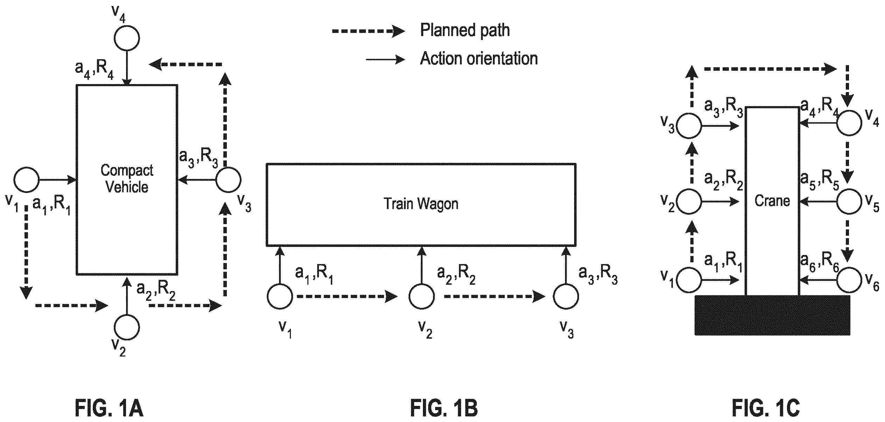

FIG. 1A to 1C illustrates examples of data acquisition for semi-controlled environments using a pre-defined viewpoint checklist, in accordance with an example implementation. Specifically, FIG. 1A illustrates an example of a vehicle with four viewpoints, FIG. 1B illustrates a train wagon with three viewpoints, and FIG. 1C illustrates a crane with six viewpoints.

Given a regular data acquisition process, the inspection viewpoint checklist $V=\{v_1, ..., v_n\}$ required to be completed by an operator(s), the image to be captured in each viewpoint $I=\{img_1, ..., img_n\}$ should satisfy the viewpoint requirements $R=\{r_1, ..., r_k\}$ where $R$ {*valid viewpoint, brightness, ... ,dimensions*}, $n>0$ and $k>0$. Each operator should capture the image $img_i$ subject to viewpoint localization $v_i$ and its requirements $R_i$ that guarantee that the $img_i$ is representative and useful. Therefore, an acquisition method should facilitate capturing images that maximize the quality of the images during the process.

Formally described in the below equation, the data acquisition method should maximize the number of pictures collected for an inspection viewpoint checklist $V$ subject to the viewpoint requirements $R$ and observed conditions (actual visual input conditions) $C=\{c_1, ... ,c_k\}$.

$$\max\left(\sum_{i=1}^{n} Q(img_i, R_i, C_i)\right)$$

where $Q$ is the quality evaluation function of the image $imgi$ $I$ for each viewpoint $vi$ $V$ and $R$ {*valid viewpoint, brightness,..,dimensions*} subject to observed conditions $Ci$ and $Ri$ where $1<=i<=n$.

In order to maximize the quality of data collected and conclusions during the inspection process, example implementations utilize a guided acquisition method. The proposed guided acquisition method improves the process of collecting visual inputs. The method with real time object detection and control evaluation can maximize quality subject to viewpoints requirements and checklist plan.

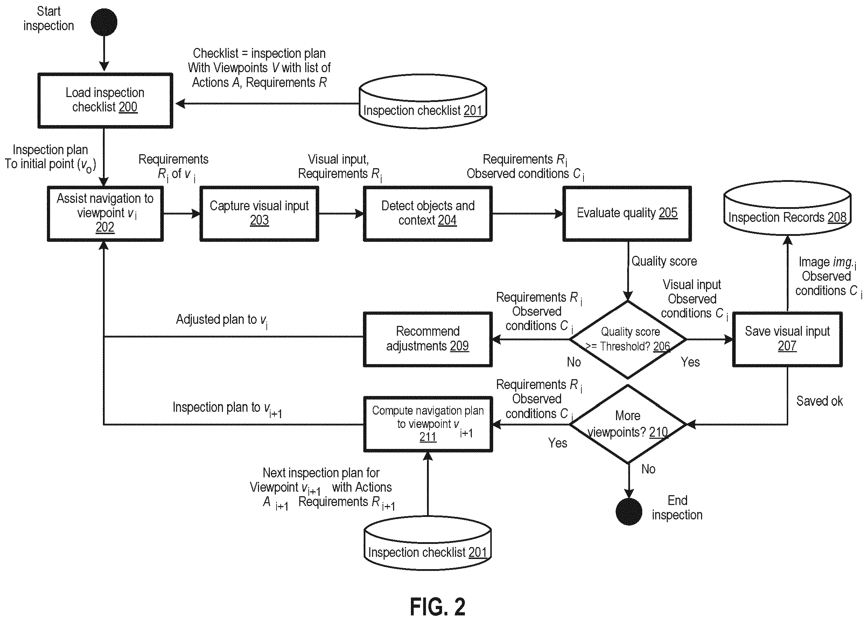

FIG. 2 illustrates an example flow for the inspection process, in accordance with an example implementation. The inspection process starts loading the planned checklist at 200 as a set of viewpoints $V$ that has to be inspected, actions $A$ to be performed, and the quality requirements $R$ to be satisfied at each viewpoint from the inspection checklist 201.

For each viewpoint in the checklist 201, the proposed method provides a data acquisition guidance with the following steps. At 202, the process assists navigation to the viewpoint $v_i$. At 203, the flow captures visual input through the input. At 204, the process identifies objects and context in the environment. At 205, the process evaluates the data quality. At 206, a determination is made as to whether the quality is satisfied. If the quality exceeds a threshold (Yes) then the process proceeds to 207 so that the visual input is recorded in the inspection records 208 along with the observed conditions $c_i$. Otherwise (No) if the quality is below the threshold, then the flow proceeds to 209 to recommend quality and navigation adjustments.

When the visual input is saved, the process also proceeds to 210 to determine if there are more viewpoints to process. If not (No), then the inspection ends. Otherwise (Yes), the process proceeds to 211 to compute the navigation recommendation to the planned next viewpoint $v_{i+1}$ based on the current state and the provided inspection checklist 201, and then proceeds to 202 to assist the navigation to the next view point. The method is completed when all viewpoints have been inspected and recorded.

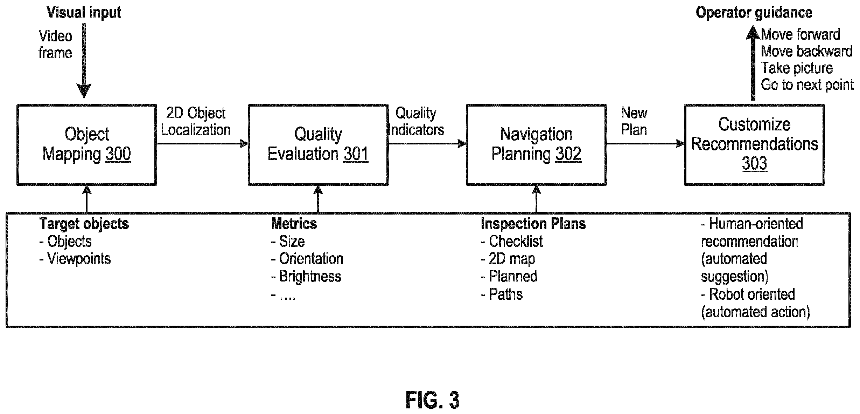

FIG. 3 illustrates the various components of the present solution, in accordance with an example implementation. The solution contains various components including object mapping 300, quality evaluation 301, navigation planning 302, and customized recommendations 303. According to the invention, Object mapping 300 includes models to identify inspection objects in 2D using the camera input. If the target object is identified, then the quality evaluation 301 uses the object content to match requirements like size, orientation, brightness, and so on. The navigation planner 302 receives the object information to generate operator guidance either for quality input adjustments or reaching a new inspection point. The customized recommendations 303 can integrate recommendations from the guidance to facilitate the operator guidance. The various components are described in detail as follows.

The object mapping component 300 estimates the state of environment given by an input image $img_i$ at time $t$ using object recognition models. The mapping method reduces the environment state to only identify the object of interest (inspection assets) such as cars, cranes or buildings from the real world. The models not only recognize the objects but - according to the invention - also provide 2D localization with a bounding box in the image. The localization information provides relevant object properties like dimensions, localization, free-obstacle regions, and so on, that enable richer quality evaluation of visual input.

The object mapping 300 uses object recognition models based on deep learning architecture which tend to be highly accurate in detecting objects in real world environments. There are two types of recognition models: classification and object detection. Classification models use convolutional neural networks (CNNs) that predict the predominant object of the image. Popular classifier architectures include MobileNet customized for mobile devices and ResNet as the state-of-the-art architecture. Object detection models not only identify the objects based on CNNs but also predict the coordinates (bounding box) where the objects are located within the image content. Popular object detection architectures include: You Only Look Once (YOLO), Single-Shot-Detection (SSD) and Faster Region-based Convolution Network (Faster-RCNN). Each model uses different approach and has different accuracy and execution time. The details of each model are as follows.

YOLO (You only look once) is a one-stage object detector that uses a single convolutional network architecture to extract features from input images and predict bounding boxes with class probabilities as regression problem. The network includes convolutional layers followed by fully connected layers. The method divides the image into a grid of d x d. Each grid cell predicts five values for B bounding boxes: x,y, width, height and confidence score. The confidence score is the likelihood that the cell has an object, computed by multiplying the probability of an object Pr(Object) with the intersection of union (IoU). It guarantees that if there is no object, then the score is zero; while the probabilities of the class are subject to how well the object is fitted in the bounding box. Yolo2 and Yolo3 are improved version of the original model. Yolo2 improves the accuracy and precision adding several techniques like batch normalization, fine granular features with ResNet-type connections, adding anchor boxes (fixed-size initial boxes). Later, Yolo3 improves upon Yolo2 by supporting multi-label classification, and adding three different feature maps with richer ResNet type of connections called Darknet.

SSD (Single-Shot-Detection) is a single-shot detector that uses default anchor boxes (fixed-size) to predict the class of the object and offset from the default box. The fixed boxes vary in scale and aspect ratio to generate different feature maps. Each feature map is responsible to detect objects on its scale. Additionally, these feature maps overlap among anchor boxes which improves precision of the object bounding box, but at the same time make the method slower than Yolo. The architecture uses classifier network (VGG-16) pre-trained using ImageNet dataset, followed by several convolutional feature layers seen as pyramid representation to extract feature maps. The detection of the object happens at each level in the pyramid that facilitates predictions of different size of objects.

Faster-RCNN (Faster Region-based Convolution Network) is a two stage detection that first detects region of interests and later predicts the class of the region. This method is a unified architecture to detect a region proposal which predicts candidate bounding boxes, followed by shared convolutional feature layers to predict if bounding boxes have objects of interest. The region proposal network is a convolutional network that predicts efficiently regions for variations in scales and aspect ratios. A region-based convolutional network is used to predict the class of the region using a fully connected layer at the end. The network also introduced a concept for RoI (Region of alignment technique as a type of max-pooling layer) that facilitates a higher precision of the bounding box prediction.

In the example implementations, models should be fast enough to detect objects with real time response (usually few milliseconds) while keeping high accuracy.

The solution includes a quality evaluation component 301 that takes the visual input and processes requirements like the size of the object in 2D, orientation, brightness, and so on. For example, the detected object should satisfy target dimensions like 640x300. Therefore, if the bounding box of the object matches these requirements, it implies that the captured image has correctly focused on the object of interest. If this is not satisfied, then the planner provides recommendations to correct the viewpoint (e.g., moving forward or backwards). A similar evaluation is done for other requirements like orientation, brightness, etc. The quality control method evaluates the below equation to determine if visual input $img_i$ matches the requirements $R_i$ as follows:

Given a visual input $img_i$ for each viewpoint $v_i$ its quality requirements $R_i=\{r_{i1}, \dots r_{ik}\}$, its observed condition $C_i=\{c_{i1}, \dots, c_{ik}\}$ and the thresholds $T_i=\{t_{i1}, \dots, t_k\}$, between observed conditions and requirements, then quality Q is defined as:

$$Q(img_i, R_i, C_i) = \begin{cases} 1, & \left|(C_{ij} - R_{ij})\right| \leq T_{ij} \quad \forall j \in k \\ 0, & otherwise \end{cases}$$

Image Quality function

The detection models analyze the image and identify objects and their quality indicators. If the object view satisfies the quality indicators, i.e., $Q((iiiiii_{ij}, RR_{ij}, CC_{ij}) = 1$, then the system automatically recommends that the image can be successfully recorded. The recommendation can be performed either by a human operator or a robot. Otherwise, the method will generate a recommendation output to adjust or find the correct viewpoint. In the robot setting, the component will trigger automatically actions to adjust the camera, while in the human setting, the component will send alerts to indicate the actions required (e.g., through an interface of a mobile device).

The solution integrates a planner component 302 which uses the object 2D identification and quality evaluation to assist the operator navigation. The approach benefits from a pre-defined checklist which denotes paths to reach valid points. For example, an operator needs to walk around the car and inspect the four tires or walk to the back and check the bumper.

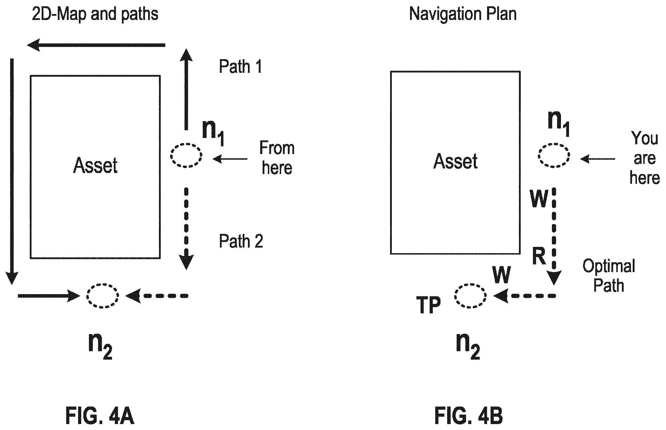

FIG. 4A illustrates an example 2D map and paths for an object, in accordance with an example implementation. The planner approach is a general framework that contains a library of inspection plans with a checklist, 2D asset map, and planned paths that the operator should follow to perform the inspection. In order to assist the operator, the planner loads a predefined plan which is transformed into two levels: logical and navigation. First, a logical plan identifies an optimal path given the current point. Second, a navigation plan derives the physical trajectory with coordinates. FIG. 4B illustrates an example logical plan, in accordance with an example implementation.

The logical plan involves a graph of nodes and edges that represent all possible inspection points connected by a path. For example, suppose the inspection A requires visiting node $n_1$ and $n_2$. Then, the logical plan will be computed as the shortest path between these two nodes based on the graph. In the navigation plan, the planner computes the trajectory and the steps to move from $n_1$ to $n_2$ and convert the logical plan to a physical plan. To do this, the planner loads the 2D map of the assets with motion meta-data which indicates how to move between a pair of nodes. The meta-data includes steps and actions like move (M), right (R), left (L), forward (F), backwards (B), take-picture (TP), etc. Finally, the trajectory is calculated with a move-action plan which is a sequence of steps to move over a planned trajectory (guidance with recommendations) to help the operator to complete the current or next inspection point as shown in FIG. 4B.

The proposed example implementations can be used in different verticals where a multi-point inspection is required. For example, transportation (trucks, vehicle, train, airplane, etc.), energy (winter binds, solar panels, powerlines), manufacturing (production line inspections), construction (buildings, roof, etc.), mining (cranes, excavators, trucks, etc.) and so on.

The inspection goals within each vertical can be related to maintenance and repair, quality control or equipment monitoring.

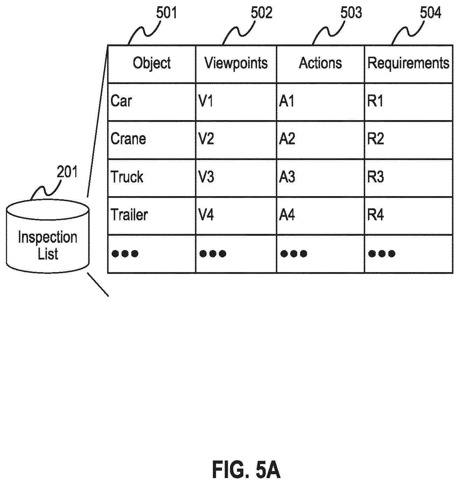

FIG. 5A illustrate an example of a management database for inspection list 201, in accordance with an example implementation. The inspection list 201 manages one or more inspection checklists for various objects 501. Each inspection checklist for an object 501 can involve a list of viewpoints 502, corresponding actions to be conducted 503, and requirements for generating appropriate images 504. Other data can also be included in the inspection checklist (e.g., type of inspection to be completed) according to the desired implementation, and the present disclosure is not limited thereto.

The list of viewpoints 502 indicate the viewpoints to inspect for a given object 501. Each viewpoint may be associated with a planned navigation path to navigate to other viewpoints in the list of viewpoints 502. Each viewpoint can also be associated with one or more requirements 504 to satisfy along with an associated artificial intelligence (AI) model to use to evaluate the current visual input, along with one or more actions 503 that are to be conducted for each viewpoint. Each viewpoint has other viewpoints that can be detected during the path, if the operator or camera deviates from the planned plan.

An example structure of the list of viewpoints can be as follows:

```
            Viewpoints "to visit{
            First_viewpoint:[{name, object_size, path_to_center',Path-_to_next_viewpoint,
        Actions: take picture, Requirements: (name,model, threshold)},
            second viewpoint[...]}},
            related viewpoints to this path{
            List of other valid viewpoints: [:[{name, object_size,
        path_to_center',Path_to_next_viewpoint, Actions: none, Requirements: (name,model,
        threshold)},
                }
```

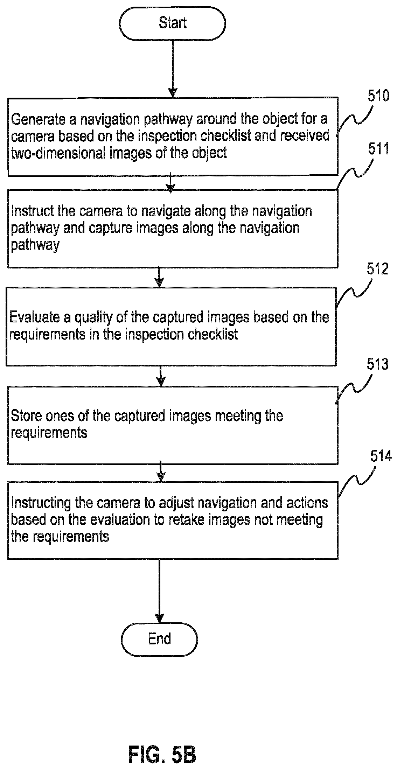

FIG. 5B illustrates an example of a flow for automating an inspection checklist for an object to be inspected, in accordance with an example implementation. At 510, the flow generates a navigation pathway around the object for a camera based on the inspection checklist and received two-dimensional images of the object. At 511, the flow instructs the camera to navigate along the navigation pathway and capture images along the navigation pathway. At 512, the flow evaluates a quality of the captured images based on the requirements in the inspection checklist. At 513, the flow stores the ones of the captured images meeting the requirements, and at 514, the flow instructs the camera to adjust navigation and actions based on the evaluation for the ones of the images not meeting the requirements.

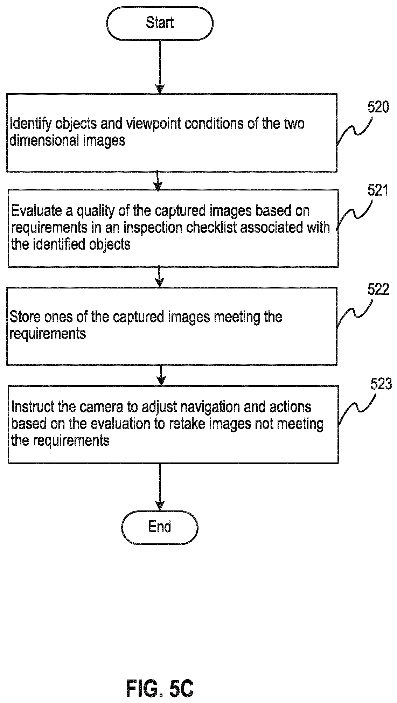

FIG. 5C illustrates a flow for a process on a plurality of two-dimensional images captured by a camera, in accordance with an example implementation. At 520, the flow identifies objects and viewpoint status from the two-dimensional images. At 521, the flow evaluates a quality of the captured images based on requirements in an inspection checklist associated with the identified objects. At 522, the flow stores the captured two-dimensional images meeting the requirements, and instructs the camera to adjust navigation and actions based on the evaluation for the other captured two-dimensional images that do not meet the requirements at 523.

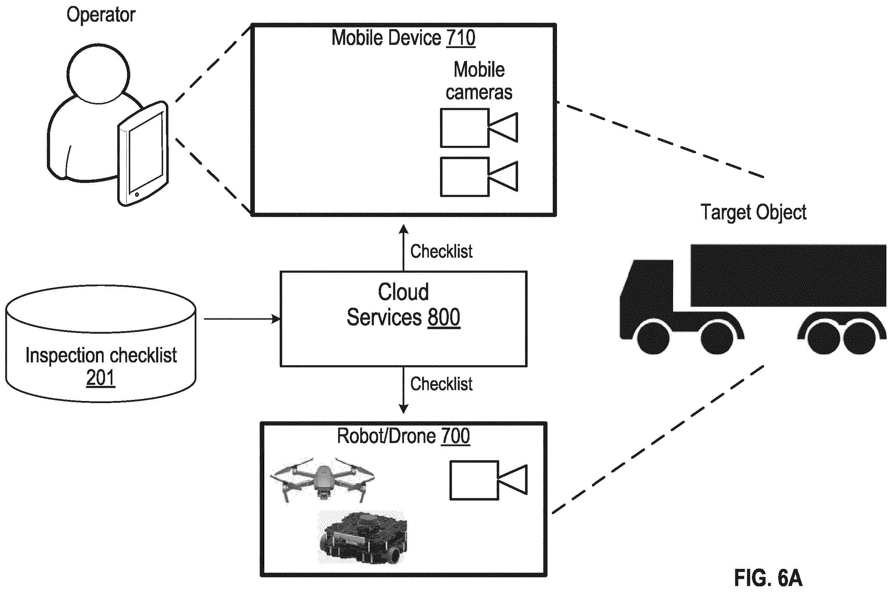

FIG. 6A illustrates an example system architecture, in accordance with an example implementation. In an example system architecture, a target object is provided at a location which can be inspected either by a robot/drone 700, or a mobile device 710. The robot/drone 700, or the mobile device 710 is communicatively connected to cloud service environment 800, which manages database and data flows such as inspection checklist 201. Cloud service environment 800 distributes the inspection checklist 201 to the corresponding robot/drone 700, or mobile device 710.

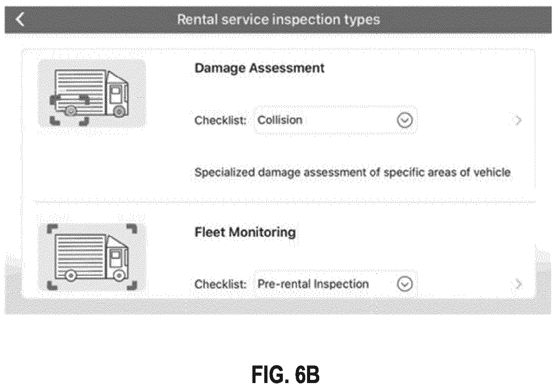

FIGS. 6B to 6F illustrate example interfaces that can be implemented on a mobile device 710 or a robot/drone 700, in accordance with an example implementation. Specifically, FIG. 6B illustrates an example interface to select an inspection type, in accordance with an example implementation. The inspection type can determine which checklists are valid for the object. For example, a damage assessment inspection can include a checklist for collision.

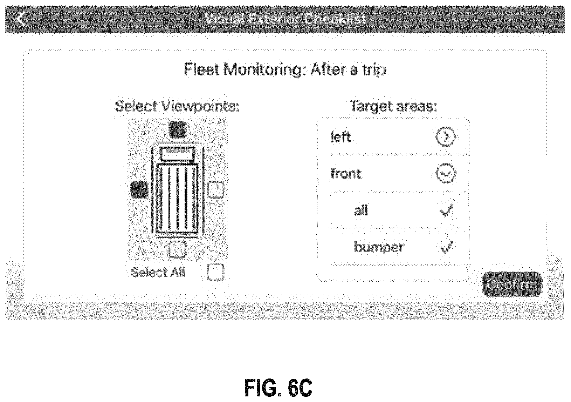

FIG. 6C illustrates an example interface for modifying/viewing a checklist, in accordance with an example implementation. In the example interface of FIG. 6C, the viewpoints can be viewed and modified within the checklist.

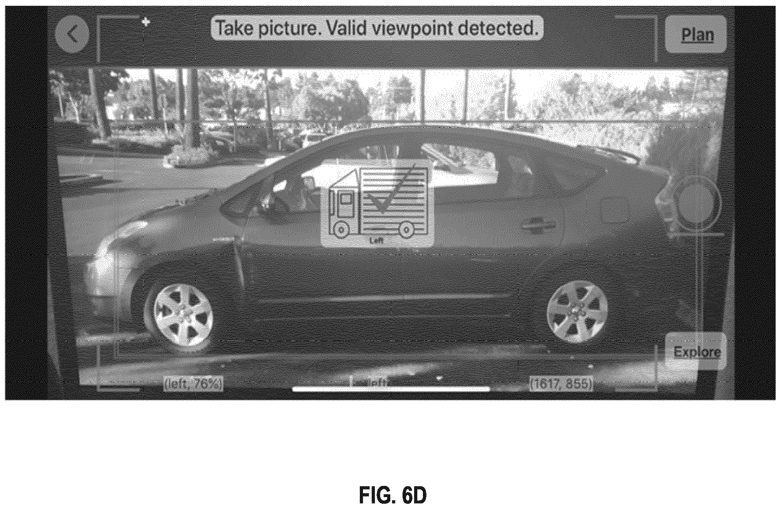

FIG. 6D illustrates an example detection of a viewpoint of interest through the camera of an robot/drone 700 or a mobile device 710. Once the viewpoints are determined from the checklist, the camera is navigated until an image of the viewpoint is obtained as illustrated in FIG. 6D. Once obtained, the corresponding action (e.g., taking a picture) can thereby be executed.

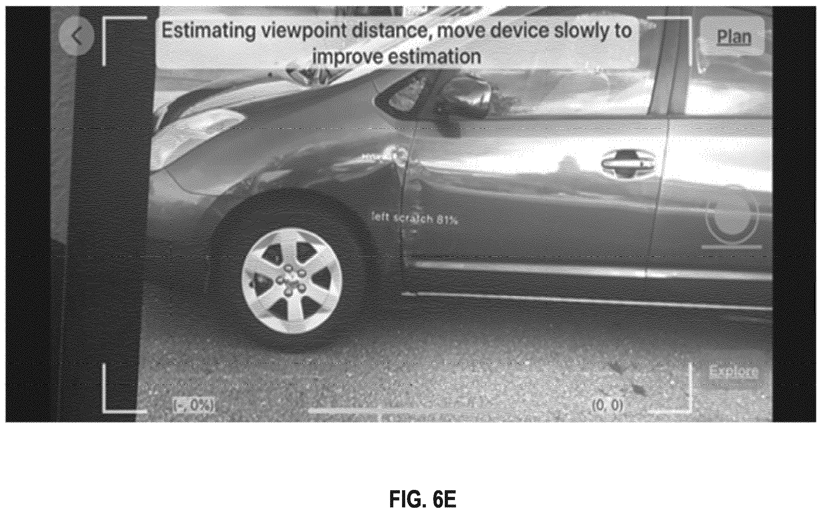

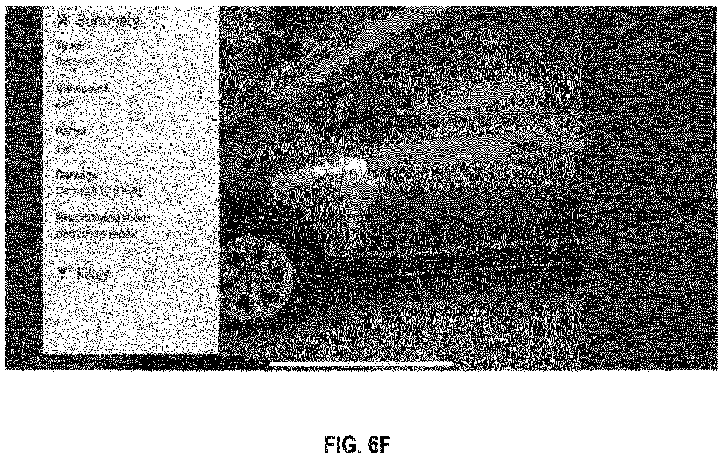

FIG. 6E illustrates an example of real time calculation of damage assessment through the interface, in accordance with an example implementation. Based on the image captured, analytics can be conducted on the image to determine damages to the object in real time. FIG. 6F illustrates example output of the damage assessment based on such analytics.

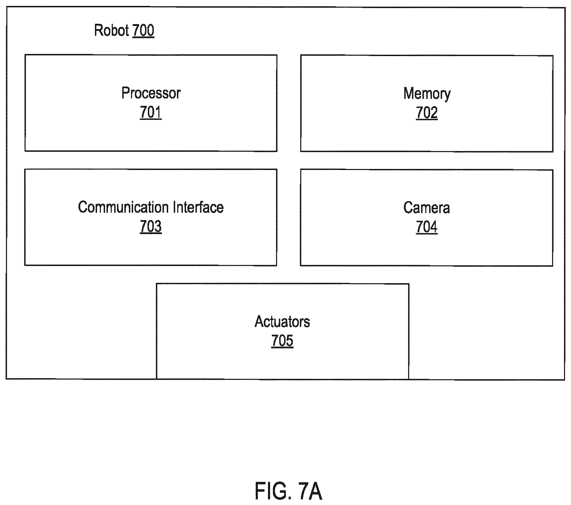

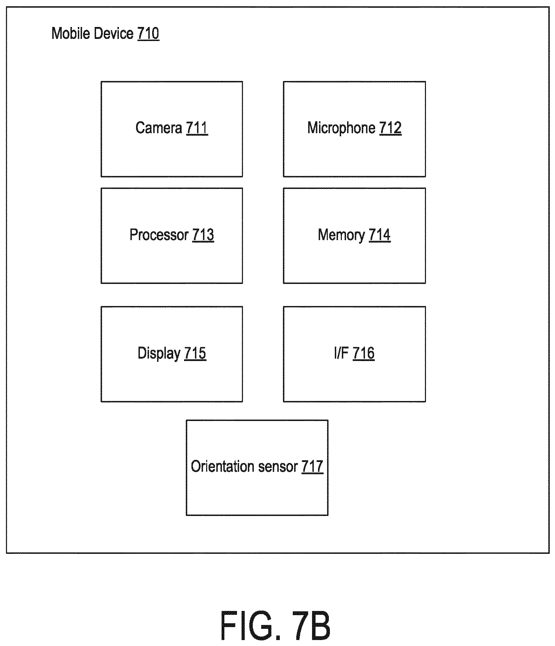

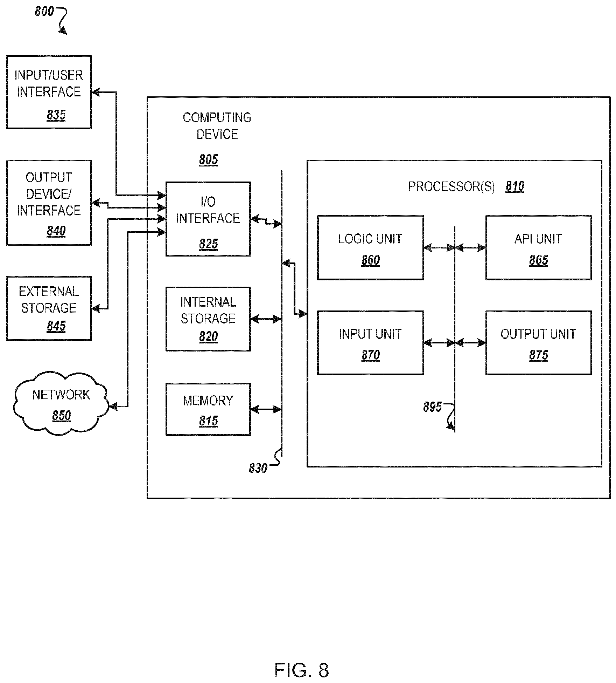

FIG. 7A illustrates an example hardware diagram for a robotic camera, in accordance with an example implementation. The robotic camera 700 may include a processor 701, a memory 702, a communication interface with a baseband processor 703, a camera 704, and one or more actuators 705. Memory 702 may store instructions that can be loaded into processor 701 such as the navigation instructions and plans as generated from the example implementations described herein. Communication interface 703 may be configured to receive instructions from the apparatus of FIG. 8, from a mobile device as illustrated in FIG. 7B, or otherwise, and store the instructions into memory 702 for execution by the processor. The camera 704 can include any type of camera in accordance with the desired implementation, such as wide-angle cameras, video cameras, and so on, to obtain camera images for the inspection, which can be sent back to the apparatus of FIG. 8 through the communication interface 703 for processing. Actuators 705 can be configured to navigate and move the robot 700 according to the desired implementation (e.g., rotors, wheel-based actuators, tread based actuators, etc.). In example implementations, the robot 700 can be in the form of a drone, a robotic arm with a camera, or any other type of movable robot with a camera in accordance with the desired implementation. Processor 701 can be configured to execute any instructions to move the robot 700 or control the camera 704 based on instructions received from cloud service environment 800.

FIG. 7B illustrates an example of a computing device, in accordance with an example implementation. Computing device can be in the form of a laptop, a personal computer, a mobile device, a tablet, or other devices in accordance with the desired implementation. Computing device 710 can include camera 711, microphone 712, processor 713, memory 714, display 715, interface (I/F) 716 and orientation sensor 717. Camera 711 can include any type of camera that is configured to record any form of video in accordance with the desired implementation. Microphone 712 can involve any form of microphone that is configured to record any form of audio in accordance with the desired implementation. Display 715 can involve a touch screen display configured to receive touch input to facilitate instructions to execute the functions as described herein, or a normal display such as a liquid crystal display (LCD) or any other display in accordance with the desired implementation. I/F 716 can include network interfaces to facilitate connections of the computing device 710 to external elements such as the server and any other device in accordance with the desired implementations. Processor 713 can be in the form of hardware processors such as central processing units (CPUs) or in a combination of hardware and software units in accordance with the desired implementation. The orientation sensor 717 can involve any form of gyroscope and/or accelerometer that is configured to measure any kind of orientation measurement, such as tilt angle, orientation with respect to x,y,z, access, acceleration (e.g., gravity) and so on in accordance with the desired implementation. Orientation sensor measurements can also involve gravity vector measurements to indicate the gravity vector of the device in accordance with the desired implementation. Computing device 710 can be utilized as a device for a local user, or a device as attached to a robot as illustrated in FIG. 7A depending on the desired implementation. Processor 713 can be configured to facilitate the functionality of the interfaces illustrated in FIGS. 6B to 6F.

FIG. 8 illustrates an example computing environment with an example computer device suitable for use in some example implementations, such as a server to facilitate cloud service environment 800. Computer device 805 in computing environment 800 can include one or more processing units, cores, or processors 810, memory 815 (e.g., RAM, ROM, and/or the like), internal storage 820 (e.g., magnetic, optical, solid state storage, and/or organic), and/or I/O interface 825, any of which can be coupled on a communication mechanism or bus 830 for communicating information or embedded in the computer device 805.

Computer device 805 can be communicatively coupled to input/user interface 835 and output device/interface 840. Either one or both of input/user interface 835 and output device/interface 840 can be a wired or wireless interface and can be detachable. Input/user interface 835 may include any device, component, sensor, or interface, physical or virtual, that can be used to provide input (e.g., buttons, touch-screen interface, keyboard, a pointing/cursor control, microphone, camera, braille, motion sensor, optical reader, and/or the like). Output device/interface 840 may include a display, television, monitor, printer, speaker, braille, or the like. In some example implementations, input/user interface 835 and output device/interface 840 can be embedded with or physically coupled to the computer device 805. In other example implementations, other computer devices may function as or provide the functions of input/user interface 835 and output device/interface 840 for a computer device 805.

Examples of computer device 805 may include, but are not limited to, highly mobile devices (e.g., smartphones, devices in vehicles and other machines, devices carried by humans and animals, and the like), mobile devices (e.g., tablets, notebooks, laptops, personal computers, portable televisions, radios, and the like), and devices not designed for mobility (e.g., desktop computers, other computers, information kiosks, televisions with one or more processors embedded therein and/or coupled thereto, radios, and the like).

Computer device 805 can be communicatively coupled (e.g., via I/O interface 825) to external storage 845 and network 850 for communicating with any number of networked components, devices, and systems, including one or more computer devices of the same or different configuration. Computer device 805 or any connected computer device can be functioning as, providing services of, or referred to as a server, client, thin server, general machine, special-purpose machine, or another label.

I/O interface 825 can include, but is not limited to, wired and/or wireless interfaces using any communication or I/O protocols or standards (e.g., Ethernet, 802.11x, Universal System Bus, WiMax, modem, a cellular network protocol, and the like) for communicating information to and/or from at least all the connected components, devices, and network in computing environment 800. Network 850 can be any network or combination of networks (e.g., the Internet, local area network, wide area network, a telephonic network, a cellular network, satellite network, and the like).

Computer device 805 can use and/or communicate using computer-usable or computer-readable media, including transitory media and non-transitory media. Transitory media include transmission media (e.g., metal cables, fiber optics), signals, carrier waves, and the like. Non-transitory media include magnetic media (e.g., disks and tapes), optical media (e.g., CD ROM, digital video disks, Blu-ray disks), solid state media (e.g., RAM, ROM, flash memory, solid-state storage), and other non-volatile storage or memory.

Computer device 805 can be used to implement techniques, methods, applications, processes, or computer-executable instructions in some example computing environments. Computer-executable instructions can be retrieved from transitory media, and stored on and retrieved from non-transitory media. The executable instructions can originate from one or more of any programming, scripting, and machine languages (e.g., C, C++, C#, Java, Visual Basic, Python, Perl, JavaScript, and others).

Processor(s) 810 can execute under any operating system (OS) (not shown), in a native or virtual environment. One or more applications can be deployed that include logic unit 860, application programming interface (API) unit 865, input unit 870, output unit 875, and inter-unit communication mechanism 895 for the different units to communicate with each other, with the OS, and with other applications (not shown). The described units and elements can be varied in design, function, configuration, or implementation and are not limited to the descriptions provided.

In some example implementations, when information or an execution instruction is received by API unit 865, it may be communicated to one or more other units (e.g., logic unit 860, input unit 870, output unit 875). In some instances, logic unit 860 may be configured to control the information flow among the units and direct the services provided by API unit 865, input unit 870, output unit 875, in some example implementations described above. For example, the flow of one or more processes or implementations may be controlled by logic unit 860 alone or in conjunction with API unit 865. The input unit 870 may be configured to obtain input for the calculations described in the example implementations, and the output unit 875 may be configured to provide output based on the calculations described in example implementations.

In example implementations, the cloud service environment 800 can be configured to automate the inspection checklist for an object to be inspected as illustrated in FIG. 6A. In such an example implementation, processor(s) 810 can be configured to execute the flow of FIG. 5B and generate a navigation pathway around the object for a camera based on the inspection checklist and received two-dimensional images of the object, instruct the camera to navigate along the navigation pathway and capture images along the navigation pathway; evaluate a quality of the captured images based on the requirements in the inspection checklist; for ones of the captured images meeting the requirements, store those images; and for other ones of the captured images not meeting the requirements, instruct the camera to adjust navigation and actions based on the evaluation as illustrated in FIGS. 1A to 4C. As illustrated in FIGS. 1A to 1C, 4A to 4B, and 5A, the inspection checklist can include one or more viewpoints of the object to be inspected, wherein the processor(s) 810 can be configured to generate the navigation pathway from the viewpoints.

As illustrated in FIG. 5A, the inspection checklist can include one or more actions to be conducted along the one or more viewpoints, wherein the instructions can include instructing the camera to conduct the one or more actions in the checklist, such as taking a picture, adjusting the lighting, pan, zoom, tilt, etc. of the camera, and so on in accordance with the desired implementation.

In an example implementation in which the camera is controlled by a robot as illustrated in FIG. 7A, processor(s) 810 can be configured to instruct the camera to navigate along the navigation pathway and capture the images along the navigation pathway by controlling the robot 700 to navigate along the navigation pathway and capture the images along the navigation pathway in real time. In such example implementations, processor(s) 810 send instructions to robot 700 to control the actuators 705 for navigation and camera 704 to capture images through communication interface 703 and processor 701. Further, processor(s) 810 can be configured to adjust the navigation and the actions based on the evaluation by controlling the robot to adjust the navigation and the actions based on the evaluation in real time through such instructions to robot 700.

In an example implementation in which a camera is integrated into a mobile device as illustrated in FIG. 7B, processor(s) 810 can be configured to instruct the camera to navigate along the navigation pathway and capture the images along the navigation pathway and instruct the camera to adjust the navigation and the actions based on the evaluation is conducted through an interface of the mobile device as illustrated in FIGS. 6B to 6F.

Processor(s) 810 can be configured to instruct the camera to adjust the navigation and the actions based on the evaluation by adjusting the actions through adjustments of one or more of a lighting of the camera, a number of images to be recaptured, a zoom level of the camera; and adjusting the navigation through adjustments of one or more of a position of the camera, and an orientation of the camera as described in FIG. 5A.

In example implementations, the cloud service environment 800 can be configured to process two-dimensional images captured by a camera as illustrated in FIG. 6A. In such an example implementation, processor(s) 810 can be configured to execute the flow of FIG. 5C and can be configured to identify objects and viewpoint status from the two-dimensional images; evaluate a quality of the captured images based on requirements in an inspection checklist associated with the identified objects; for ones of the two-dimensional images meeting the requirements, store those images; and for other ones of the captured images not meeting the requirements, instructing the camera to adjust navigation and actions based on the evaluation as illustrated in FIGS. 1A to 4C. Processor(s) 810 can be configured to identify objects and the viewpoint status from the two-dimensional images by executing object recognition models to identify the objects through localizing target objects; wherein the viewpoint status is evaluated according to one or more of size of the objects, orientation, or lighting conditions as illustrated in FIG. 3.

Some portions of the detailed description are presented in terms of algorithms and symbolic representations of operations within a computer. These algorithmic descriptions and symbolic representations are the means used by those skilled in the data processing arts to convey the essence of their innovations to others skilled in the art. An algorithm is a series of defined steps leading to a desired end state or result. In example implementations, the steps carried out require physical manipulations of tangible quantities for achieving a tangible result.

Unless specifically stated otherwise, as apparent from the discussion, it is appreciated that throughout the description, discussions utilizing terms such as "processing," "computing," "calculating," "determining," "displaying," or the like, can include the actions and processes of a computer system or other information processing device that manipulates and transforms data represented as physical (electronic) quantities within the computer system's registers and memories into other data similarly represented as physical quantities within the computer system's memories or registers or other information storage, transmission or display devices.

Example implementations may also relate to an apparatus for performing the operations herein. This apparatus may be specially constructed for the required purposes, or it may include one or more general-purpose computers selectively activated or reconfigured by one or more computer programs. Such computer programs may be stored in a computer readable medium, such as a computer-readable storage medium or a computer-readable signal medium. A computer-readable storage medium may involve tangible mediums such as, but not limited to optical disks, magnetic disks, read-only memories, random access memories, solid state devices and drives, or any other types of tangible or non-transitory media suitable for storing electronic information. A computer readable signal medium may include mediums such as carrier waves. The algorithms and displays presented herein are not inherently related to any particular computer or other apparatus. Computer programs can involve pure software implementations that involve instructions that perform the operations of the desired implementation.

Various general-purpose systems may be used with programs and modules in accordance with the examples herein, or it may prove convenient to construct a more specialized apparatus to perform desired method steps. In addition, the example implementations are not described with reference to any particular programming language. It will be appreciated that a variety of programming languages may be used to implement the teachings of the example implementations as described herein. The instructions of the programming language(s) may be executed by one or more processing devices, e.g., central processing units (CPUs), processors, or controllers.

As is known in the art, the operations described above can be performed by hardware, software, or some combination of software and hardware. Various aspects of the example implementations may be implemented using circuits and logic devices (hardware), while other aspects may be implemented using instructions stored on a machine-readable medium (software), which if executed by a processor, would cause the processor to perform a method to carry out implementations of the present application. Further, some example implementations of the present application may be performed solely in hardware, whereas other example implementations may be performed solely in software. Moreover, the various functions described can be performed in a single unit, or can be spread across a number of components in any number of ways. When performed by software, the methods may be executed by a processor, such as a general purpose computer, based on instructions stored on a computer-readable medium. If desired, the instructions can be stored on the medium in a compressed and/or encrypted format.

Moreover, other implementations of the present application will be apparent to those skilled in the art from consideration of the specification and practice of the teachings of the present application. Various aspects and/or components of the described example implementations may be used singly or in any combination. It is intended that the specification and example implementations be considered as examples only, with the true scope of the present application being indicated by the following claims.

## Claims

1. A non-transitory computer readable medium, storing instructions for automating a processing of an inspection checklist (201) for an object (501) to be inspected, the instructions comprising:

   capturing two-dimensional images of the object by a camera and generating a navigation pathway around the object (501) for the camera (704) based on the inspection checklist (201) and captured two-dimensional images of the object, wherein the object (501) is localized in 2D using an object mapping (300) including models to identify the object (501) in 2D using the camera images, wherein the models provide 2D localization with a bounding box in the camera images;
   instructing the camera (704) to navigate along the navigation pathway and capture images along the navigation pathway;
   evaluating a quality of the captured images based on requirements (504) in the inspection checklist (201);
   for ones of the captured images meeting the requirements (504), storing those images; and
   for other ones of the captured images not meeting the requirements (504), instructing the camera (704) to adjust navigation through adjustments of one or more of a position of the camera (704) and an orientation of the camera (704), and adjust actions through adjustments of one or more of a lighting of the camera (704), a number of images to be recaptured, a zoom level of the camera (704), to adjust the camera based on the evaluation.

2. The non-transitory computer readable medium of claim 1, wherein the inspection checklist (201) comprises one or more viewpoints (502) of the object (501) to be inspected, wherein the navigation pathway is generated from the viewpoints (502).

3. The non-transitory computer readable medium of claim 2, wherein the inspection checklist (201) comprises one or more actions to be conducted along the one or more viewpoints (502), wherein the instructions further comprises instructing the camera (704) to conduct the one or more actions in the checklist (201).

4. The non-transitory computer readable medium of claim 1, wherein the camera (704) is controlled by a robot (700),

   wherein the instructing the camera (704) to navigate along the navigation pathway and capture the images along the navigation pathway comprises controlling the robot (700) to navigate along the navigation pathway and capture the images along the navigation pathway in real time;
   wherein the instructing the camera (704) to adjust the navigation and the actions based on the evaluation comprises controlling the robot to adjust the navigation and the actions based on the evaluation in real time.

5. The non-transitory computer readable medium of claim 1, wherein the camera (704) is integrated into a mobile device (710), wherein the instructing the camera (704) to navigate along the navigation pathway and capture the images along the navigation pathway and the instructing the camera (704) to adjust the navigation and the actions based on the evaluation is conducted through a user interface (716) of the mobile device.

6. A method for automating a processing of an inspection checklist (201) for an object (501) to be inspected, the method comprising:

capturing two-dimensional images of the object by a camera and generating a navigation pathway around the object (501) for the camera (704) based on the inspection checklist (201) and captured two-dimensional images of the object (501), wherein the object (501) is localized in 2D using an object mapping (300) including models to identify the object (501) in 2D using the camera images, wherein the models provide 2D localization with a bounding box in the camera images;

instructing the camera (704) to navigate along the navigation pathway and capture images along the navigation pathway;

evaluating a quality of the captured images based on requirements (504) in the inspection checklist (201);

for ones of the captured images meeting the requirements (504), storing those images; and

for other ones of the captured images not meeting the requirements (504), instructing the camera (704) to adjust navigation by adjustments of one or more of a position of the camera (704) and an orientation of the camera (704), and actions through adjustments of one or more of a lighting of the camera (704), a number of images to be recaptured, a zoom level of the camera (704), to adjust the camera based on the evaluation.

7. The method of claim 6, wherein the inspection checklist (201) comprises one or more viewpoints (502) of the object (501) to be inspected, wherein the generating the navigation pathway is generated from the viewpoints (502).

8. The method of claim 6, wherein the inspection checklist (201) comprises one or more actions to be conducted along the one or more viewpoints (502), wherein the instructions further comprises instructing the camera (704) to conduct the one or more actions in the checklist (201).

9. The method of claim 6, wherein the camera (704) is controlled by a robot (700),

wherein the instructing the camera (704) to navigate along the navigation pathway and capture the images along the navigation pathway comprises controlling the robot (700) to navigate along the navigation pathway and capture the images along the navigation pathway in real time;

wherein the instructing the camera (704) to adjust the navigation and the actions based on the evaluation comprises controlling the robot (700) to adjust the navigation and the actions based on the evaluation in real time.

10. The method of claim 6, wherein the camera (704) is integrated into a mobile device (710), wherein the instructing the camera (704) to navigate along the navigation pathway and capture the images along the navigation pathway and the instructing the camera (704) to adjust the navigation and the actions based on the evaluation is conducted through a user interface (716) of the mobile device (710).

**Patentansprüche**

1. Nichtflüchtiges computerlesbares Medium, das Anweisungen zum Automatisieren einer Verarbeitung einer Inspektionscheckliste (201) für ein zu inspizierendes Objekt (501) speichert, wobei die Anweisungen umfassen:

Erfassen von zweidimensionalen Bildern des Objekts durch eine Kamera und Erzeugen eines Navigationspfads um das Objekt (501) für die Kamera (704) basierend auf der Inspektionscheckliste (201) und erfassten zweidimensionalen Bildern des Objekts, wobei das Objekt (501) in 2D unter Verwendung einer Objektabbildung (300) lokalisiert wird, die Modelle zum Identifizieren des Objekts (501) in 2D unter Verwendung der Kamerabilder umfasst, wobei die Modelle eine 2D-Lokalisierung mit einem Begrenzungsrahmen in den Kamerabildern bereitstellen;

Anweisen der Kamera (704), entlang des Navigationspfads zu navigieren und Bilder entlang des Navigationspfads zu erfassen;

Bewerten einer Qualität der erfassten Bilder basierend auf Anforderungen (504) in der Inspektionscheckliste (201);

für einige der erfassten Bilder, die die Anforderungen (504) erfüllen, Speichern dieser Bilder; und

für andere der erfassten Bilder, die die Anforderungen (504) nicht erfüllen, Anweisen der Kamera (704), die Navigation durch Anpassungen von einem oder mehreren von einer Position der Kamera (704) und einer Ausrichtung der Kamera (704) anzupassen und Aktionen durch Anpassungen von einem oder mehreren von einer Beleuchtung der Kamera (704), einer Anzahl von Bildern, die erneut erfasst werden sollen, einer Zoomstufe der Kamera (704) anzupassen, um die Kamera basierend auf der Bewertung anzupassen.

2. Nichtflüchtiges computerlesbares Medium nach Anspruch 1, wobei die Inspektionscheckliste (201) einen oder mehrere Blickpunkte (502) des zu inspizierenden Objekts (501) umfasst, wobei der Navigationspfad aus den Blickpunkten (502) erzeugt wird.

3. Nichtflüchtiges computerlesbares Medium nach Anspruch 2, wobei die Inspektionscheckliste (201) eine oder mehrere Aktionen umfasst, die entlang des einen oder der mehreren Blickpunkte (502) durchgeführt werden sollen, wobei die Anweisungen ferner das Anweisen der Kamera (704), die eine oder die mehreren Aktionen in der Checkliste (201) durchzuführen, umfassen.

4. Nichtflüchtiges computerlesbares Medium nach Anspruch 1, wobei die Kamera (704) von einem Roboter (700) gesteuert wird,

   wobei das Anweisen der Kamera (704), entlang des Navigationspfads zu navigieren und die Bilder entlang des Navigationspfads zu erfassen, das Steuern des Roboters (700) umfasst, um entlang des Navigationspfads zu navigieren und die Bilder entlang des Navigationspfads in Echtzeit zu erfassen;
   wobei das Anweisen der Kamera (704), die Navigation und die Aktionen basierend auf der Bewertung anzupassen, das Steuern des Roboters umfasst, um die Navigation und die Aktionen basierend auf der Bewertung in Echtzeit anzupassen.

5. Nichtflüchtiges computerlesbares Medium nach Anspruch 1, wobei die Kamera (704) in eine mobile Vorrichtung (710) integriert ist, wobei das Anweisen der Kamera (704), entlang des Navigationspfads zu navigieren und die Bilder entlang des Navigationspfads zu erfassen, und das Anweisen der Kamera (704), die Navigation und die Aktionen basierend auf der Bewertung anzupassen, durch eine Benutzerschnittstelle (716) der mobilen Vorrichtung durchgeführt werden.

6. Verfahren zum Automatisieren einer Verarbeitung einer Inspektionscheckliste (201) für ein zu inspizierendes Objekt (501), wobei das Verfahren umfasst:

   Erfassen von zweidimensionalen Bildern des Objekts durch eine Kamera und Erzeugen eines Navigationspfads um das Objekt (501) für die Kamera (704) basierend auf der Inspektionscheckliste (201) und erfassten zweidimensionalen Bildern des Objekts (501), wobei das Objekt (501) in 2D unter Verwendung einer Objektabbildung (300) lokalisiert wird, die Modelle zum Identifizieren des Objekts (501) in 2D unter Verwendung der Kamerabilder umfasst, wobei die Modelle eine 2D-Lokalisierung mit einem Begrenzungsrahmen in den Kamerabildern bereitstellen;
   Anweisen der Kamera (704), entlang des Navigationspfads zu navigieren und Bilder entlang des Navigationspfads zu erfassen;
   Bewerten einer Qualität der erfassten Bilder basierend auf Anforderungen (504) in der Inspektionscheckliste (201);
   für einige der erfassten Bilder, die die Anforderungen (504) erfüllen, Speichern dieser Bilder; und
   für andere der erfassten Bilder, die die Anforderungen (504) nicht erfüllen, Anweisen der Kamera (704), die Navigation durch Anpassungen von einem oder mehreren von einer Position der Kamera (704) und einer Ausrichtung der Kamera (704) anzupassen und Aktionen durch Anpassungen von einem oder mehreren von einer Beleuchtung der Kamera (704), einer Anzahl von Bildern, die erneut erfasst werden sollen, einer Zoomstufe der Kamera (704) anzupassen, um die Kamera basierend auf der Bewertung anzupassen.

7. Verfahren nach Anspruch 6, wobei die Inspektionscheckliste (201) einen oder mehrere Blickpunkte (502) des zu inspizierenden Objekts (501) umfasst, wobei das Erzeugen des Navigationspfads aus den Blickpunkten (502) erzeugt wird.

8. Verfahren nach Anspruch 6, wobei die Inspektionscheckliste (201) eine oder mehrere Aktionen umfasst, die entlang des einen oder der mehreren Blickpunkte (502) durchgeführt werden sollen, wobei die Anweisungen ferner das Anweisen der Kamera (704), die eine oder die mehreren Aktionen in der Checkliste (201) durchzuführen, umfassen.

9. Verfahren nach Anspruch 6, wobei die Kamera (704) von einem Roboter (700) gesteuert wird,

   wobei das Anweisen der Kamera (704), entlang des Navigationspfads zu navigieren und die Bilder entlang des Navigationspfads zu erfassen, das Steuern des Roboters (700) umfasst, um entlang des Navigationspfads zu navigieren und die Bilder entlang des Navigationspfads in Echtzeit zu erfassen;
   wobei das Anweisen der Kamera (704), die Navigation und die Aktionen basierend auf der Bewertung anzupassen, das Steuern des Roboters (700) umfasst, um die Navigation und die Aktionen basierend auf der Bewertung in Echtzeit anzupassen.

10. Verfahren nach Anspruch 6, wobei die Kamera (704) in eine mobile Vorrichtung (710) integriert ist, wobei das Anweisen der Kamera (704), entlang des Navigationspfads zu navigieren und die Bilder entlang des Navigationspfads zu erfassen, und das Anweisen der Kamera (704), die Navigation und die Aktionen basierend auf der Bewertung anzupassen, durch eine Benutzerschnittstelle (716) der mobilen Vorrichtung (710) durchgeführt werden.

**Revendications**

1. Support non transitoire lisible par ordinateur, stockant des instructions pour automatiser un traitement d'une liste de contrôle d'inspection (201) pour un objet (501) à inspecter, les instructions comprenant de :

capturer des images bidimensionnelles de l'objet via une caméra et générer une trajectoire de navigation autour de l'objet (501) pour la caméra (704) sur la base de la liste de contrôle d'inspection (201) et des images bidimensionnelles capturées de l'objet, l'objet (501) étant localisé en 2D à l'aide d'un mappage d'objet (300) incluant des modèles pour identifier l'objet (501) en 2D à l'aide des images de caméra, les modèles fournissant une localisation 2D avec une boîte de délimitation dans les images de caméra ;
donner instruction à la caméra (704) de naviguer le long de la trajectoire de navigation et de capturer des images le long de la trajectoire de navigation ;
évaluer une qualité des images capturées sur la base de prérequis (504) dans la liste de contrôle d'inspection (201) ;
pour certaines des images capturées satisfaisant aux prérequis (504), stocker ces images ; et
pour certaines autres des images capturées ne satisfaisant pas aux prérequis (504), donner instruction à la caméra (704) d'ajuster une navigation par le biais d'ajustements d'un ou de plusieurs paramètres parmi une position de la caméra (704) et une orientation de la caméra (704), et d'ajuster des actions par le biais d'ajustements d'un ou de plusieurs paramètres parmi un éclairage de la caméra (704), un nombre d'images à recapturer, un niveau d'agrandissement de la caméra (704), pour ajuster la caméra sur la base de l'évaluation.

2. Support non transitoire lisible par ordinateur selon la revendication 1, dans lequel la liste de contrôle d'inspection (201) comprend un ou plusieurs points de vue (502) de l'objet (501) à inspecter, la trajectoire de navigation étant générée à partir des points de vue (502).

3. Support non transitoire lisible par ordinateur selon la revendication 2, dans lequel la liste de contrôle d'inspection (201) comprend une ou plusieurs actions à exécuter le long desdits un ou plusieurs points de vue (502), les instructions comprenant en outre de donner instruction à la caméra (704) d'exécuter lesdites une ou plusieurs actions dans la liste de contrôle (201).

4. Support non transitoire lisible par ordinateur selon la revendication 1, dans lequel la caméra (704) est commandée par un robot (700),

dans lequel l'instruction de la caméra (704) de naviguer le long de la trajectoire de navigation et de capturer les images le long de la trajectoire de navigation comprend de commander le robot (700) pour le faire naviguer le long de la trajectoire de navigation et capturer les images le long de la trajectoire de navigation en temps réel ;
dans lequel l'instruction de la caméra (704) d'ajuster la navigation et les actions sur la base de l'évaluation comprend de commander le robot pour le faire ajuster la navigation et les actions sur la base de l'évaluation en temps réel.

5. Support non transitoire lisible par ordinateur selon la revendication 1, dans lequel la caméra (704) est intégrée dans un dispositif mobile (710), l'instruction de la caméra (704) de naviguer le long de la trajectoire de navigation et de capturer les images le long de la trajectoire de navigation et l'instruction de la caméra (704) d'ajuster la navigation et les actions sur la base de l'évaluation étant exécutées via une interface utilisateur (716) du dispositif mobile.

6. Procédé d'automatisation d'un traitement d'une liste de contrôle d'inspection (201) pour un objet (501) à inspecter, le procédé comprenant les étapes consistant à :

capturer des images bidimensionnelles de l'objet via une caméra et générer une trajectoire de navigation autour de l'objet (501) pour la caméra (704) sur la base de la liste de contrôle d'inspection (201) et des images bidimensionnelles capturées de l'objet (501), l'objet (501) étant localisé en 2D à l'aide d'un mappage d'objet (300) incluant des modèles pour identifier l'objet (501) en 2D à l'aide des images de caméra, les modèles fournissant une localisation 2D avec une boîte de délimitation dans les images de caméra ;

donner instruction à la caméra (704) de naviguer le long de la trajectoire de navigation et de capturer des images le long de la trajectoire de navigation ;

évaluer une qualité des images capturées sur la base de prérequis (504) dans la liste de contrôle d'inspection (201) ;

pour certaines des images capturées satisfaisant aux prérequis (504), stocker ces images ; et

pour certaines autres des images capturées ne satisfaisant pas aux prérequis (504), donner instruction à la caméra (704) d'ajuster une navigation par le biais d'ajustements d'un ou de plusieurs paramètres parmi une position de la caméra (704) et une orientation de la caméra (704), et d'actions par le biais d'ajustements d'un ou de plusieurs paramètres parmi un éclairage de la caméra (704), un nombre d'images à recapturer, un niveau d'agrandissement de la caméra (704), pour ajuster la caméra sur la base de l'évaluation.

7. Procédé selon la revendication 6, dans lequel la liste de contrôle d'inspection (201) comprend un ou plusieurs points de vue (502) de l'objet (501) à inspecter, la génération de la trajectoire de navigation étant générée à partir des points de vue (502).

8. Procédé selon la revendication 6, dans lequel la liste de contrôle d'inspection (201) comprend une ou plusieurs actions à exécuter le long desdits un ou plusieurs points de vue (502), les instructions comprenant en outre de donner instruction à la caméra (704) d'exécuter lesdites une ou plusieurs actions dans la liste de contrôle (201).

9. Procédé selon la revendication 6, dans lequel la caméra (704) est commandée par un robot (700),

dans lequel l'instruction de la caméra (704) de naviguer le long de la trajectoire de navigation et de capturer les images le long de la trajectoire de navigation comprend de commander le robot (700) pour le faire naviguer le long de la trajectoire de navigation et capturer les images le long de la trajectoire de navigation en temps réel ;

dans lequel l'instruction de la caméra (704) d'ajuster la navigation et les actions sur la base de l'évaluation comprend de commander le robot (700) pour lui faire ajuster la navigation et les actions sur la base de l'évaluation en temps réel.

10. Procédé selon la revendication 6, dans lequel la caméra (704) est intégrée dans un dispositif mobile (710), l'instruction de la caméra (704) de naviguer le long de la trajectoire de navigation et de capturer les images le long de la trajectoire de navigation et l'instruction de la caméra (704) d'ajuster la navigation et les actions sur la base de l'évaluation étant exécutées via une interface utilisateur (716) du dispositif mobile (710).

FIG. 1A

FIG. 1B

FIG. 1C

FIG. 2

Start inspection

Load inspection checklist 200

Inspection checklist 201

Checklist = inspection plan
With Viewpoints $V$ with list of Actions $A$, Requirements $R$

Inspection plan
To initial point ($v_0$)

Assist navigation to viewpoint $v_i$ 202

Requirements $R_i$ of $v_i$

Capture visual input 203

Visual input, Requirements $R_i$

Detect objects and context 204

Requirements $R_i$
Observed conditions $C_i$

Evaluate quality 205

Quality score

Quality score >= Threshold? 206

Visual input
Observed conditions $C_i$

Yes

Save visual input 207

Image $img_{i,j}$
Observed conditions $C_i$

Inspection Records 208

No

Requirements $R_i$
Observed conditions $C_i$

Recommend adjustments 209

Adjusted plan to $v_i$

More viewpoints? 210

No

End inspection

Yes

Requirements $R_i$
Observed conditions $C_i$

Compute navigation plan to viewpoint $v_{i+1}$ 211

Inspection checklist 201

Next inspection plan for
Viewpoint $v_{i+1}$ with Actions $A_{i+1}$ Requirements $R_{i+1}$

Inspection plan to $v_{i+1}$

Saved ok

17

**Visual input**

Video
frame

**Operator guidance**

Move forward
Move backward
Take picture
Go to next point

```
┌──────────────┐  2D Object   ┌──────────────┐  Quality    ┌──────────────┐  New   ┌──────────────┐
│   Object     │  Localization│   Quality    │  Indicators │  Navigation  │  Plan  │  Customize   │
│ Mapping 300  │─────────────▶│Evaluation 301│────────────▶│ Planning 302 │───────▶│Recommendations│
│              │              │              │             │              │        │    303       │
└──────────────┘              └──────────────┘             └──────────────┘        └──────────────┘
```

**Target objects**
- Objects
- Viewpoints

**Metrics**
- Size
- Orientation
- Brightness
- ....

**Inspection Plans**
- Checklist
- 2D map
- Planned
- Paths

- Human-oriented
  recommendation
  (automated
  suggestion)
- Robot oriented
  (automated action)

**FIG. 3**

2D-Map and paths

Path 1

$n_1$

From here

Asset

Path 2

$n_2$

FIG. 4A

Navigation Plan

$n_1$

You are here

Asset

W

R

Optimal Path

W

TP

$n_2$

FIG. 4B

| Object | Viewpoints | Actions | Requirements |
|--------|-----------|---------|--------------|
| Car | V1 | A1 | R1 |
| Crane | V2 | A2 | R2 |
| Truck | V3 | A3 | R3 |
| Trailer | V4 | A4 | R4 |
| ••• | ••• | ••• | ••• |

501  502  503  504

201

Inspection List

**FIG. 5A**

Start

Generate a navigation pathway around the object for a camera based on the inspection checklist and received two-dimensional images of the object — 510

Instruct the camera to navigate along the navigation pathway and capture images along the navigation pathway — 511

Evaluate a quality of the captured images based on the requirements in the inspection checklist — 512

Store ones of the captured images meeting the requirements — 513

Instructing the camera to adjust navigation and actions based on the evaluation to retake images not meeting the requirements — 514

End

**FIG. 5B**

Start

Identify objects and viewpoint conditions of the two dimensional images — 520

Evaluate a quality of the captured images based on requirements in an inspection checklist associated with the identified objects — 521

Store ones of the captured images meeting the requirements — 522

Instruct the camera to adjust navigation and actions based on the evaluation to retake images not meeting the requirements — 523

End

**FIG. 5C**

FIG. 6A

**FIG. 6B**

**Visual Exterior Checklist**

Fleet Monitoring: After a trip

Select Viewpoints:

Target areas:

Select All

left

front

all ✓

bumper ✓

Confirm

FIG. 6C

FIG. 6D

FIG. 6E

FIG. 6F

Robot 700

Processor
701

Memory
702

Communication Interface
703

Camera
704

Actuators
705

FIG. 7A

Mobile Device 710

Camera 711

Microphone 712

Processor 713

Memory 714

Display 715

I/F 716

Orientation sensor 717

FIG. 7B

800

COMPUTING
DEVICE

805

INPUT/USER
INTERFACE

835

OUTPUT
DEVICE/
INTERFACE

840

EXTERNAL
STORAGE

845

NETWORK

850

I/O
INTERFACE

825

INTERNAL
STORAGE

820

MEMORY

815

830

PROCESSOR(S)  810

LOGIC UNIT

860

API UNIT

865

INPUT UNIT

870

OUTPUT UNIT

875

895

FIG. 8

31

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2018321692 A1
- US 2017345317 A1
- US 20200111267 A1
- US 20230206387 A1